**Europäisches Patentamt**

**European Patent Office**

**Office européen des brevets**

(19)

(11) Veröffentlichungsnummer: **0 253 420**
**A1**

(12) # EUROPÄISCHE PATENTANMELDUNG

(21) Anmeldenummer: **87201178.8**

(22) Anmeldetag: **19.06.87**

(51) Int. Cl.⁴: **C25F 3/12** , C25F 3/14 , H01L 21/306 , //G01L9/00

(30) Priorität: **23.06.86 CH 2523/86**

(43) Veröffentlichungstag der Anmeldung:
**20.01.88 Patentblatt 88/03**

(84) Benannte Vertragsstaaten:
**CH DE FR GB IT LI NL SE**

(71) Anmelder: **Stiftung Hasler Werke**
**Belpstrasse 23**
**CH-3000 Bern 14(CH)**

(72) Erfinder: **Kloeck, Benjamin**
**Troncs 6**
**CH-2003 Neuchâtel(CH)**
Erfinder: **de Rooij, Nicolaas Frans, Dr. Prof.**
**Rue des Croix 15**
**CH-2014 Bôle(CH)**

(74) Vertreter: **Schwerdtel, Eberhard, Dr.**
**c/o Hasler AG Belpstrasse 23**
**CH-3000 Bern 14(CH)**

(54) **Anordnung und Verfahren zum elektrochemischen Aetzen von Silizium.**

(57) Die Siliziumscheibe (11) umfasst eine dünnere n-leitende Schicht (31) und eine dickere, zu ätzende, p-leitende Schicht (32). Jede dieser Schichten (31, 32) ist mit einem ohmischen Kontakt (34, 35) versehen, zwischen denen eine Spannungsquelle (38) liegt. Die p-leitende Schicht (32) ist durch eine Ätzmaske (33) teilweise abgedeckt. Die Siliziumscheibe (11) befindet sich zusammen mit einer Gegenelektrode (20) und einer Referenzelektrode (21) in einem Ätzbad.

Die Potentiale werden durch ein 3-Elektroden-Potentiostat (23) so eingestellt, dass die p-leitende Schicht (32) um etwa 1,5 V negativ gegenüber der Referenzelektrode (21) und der Ätzflüssigkeit (15) gepolt ist. Die n-leitende Schicht (31) ist gegenüber der p-leitenden Schicht (32) um etwa 1 bis 2 V positiv vorgespannt, wodurch sich eine Sperrschicht (40) an der Grenze zwischen den Schichten (31, 32) ausbildet.

Die Anordnung ermöglicht das Ätzen von Silizium mit wohldefiniertem Ätzstopp an der Sperrschicht (40). Die Ätztoleranz beträgt etwa ± 0,3 μm.

Fig. 2

## Anordnung und Verfahren zum elektrochemischen Ätzen von Silizium

Die Erfindung betrifft eine Anordnung und ein Verfahren zum elektrochemischen Ätzen von Silizium entsprechend den Oberbegriffen der unabhängigen Ansprüche.

Von H.A. Waggener, J.V. Dalton, "Control of silicon etch rates in hot alkaline solutions by externally applied potentials", ECS Extended Abstracts No 237, Fall Meeting, 1972, Miami, Florida. und H.A. Waggener "Electrochemically controlled thinning of silicon", Bell Syst. Tech. J., 49(3), 473 (1970) ist es bekannt, Silizium in Kalilauge elektrochemisch zu Ätzen, wobei an einer Grenzschicht zwischen n-leitendem und p-leitendem Silizium ein Ätzstopp stattfindet.

Aus T.N. Jackson, M.A. Tischler, K.D. Wise, "An electrochemical p-n junction etch-stop for the formation of silicon microstructures", IEEE Elect. Dev. Lett. EDL2(2), 44 (1981) und M. Hirata, S. Suwazono, H. Tanigawa, "A silicon diaghragm formation for pressure sensor by anodic oxidation etch-stop". Transducers '85, Philadelphia, ist es weiter bekannt, dünne Siliziumschichten durch elektrochemisches Ätzen herzustellen, wobei Äthylendiamin bzw. Hydrazin/Wasser als Ätzflüssigkeit benützt wird.

Bei den aus den zitierten Schriften bekannten Ätzmethoden wird jeweils ein Ätzbad mit zwei Elektroden verwendet. Die entsprechend einer Maske zu ätzende Siliziumscheibe bildet dabei die eine dieser Elektroden. Die Siliziumscheibe ist hierbei an ihrer n-leitenden Schicht elektrisch kontaktiert, während die p-leitende Schicht an ihrer in (100)-Richtung orientierten Oberfläche anisotrop abgeätzt wird. Sobald an einer Stelle die p-Schicht vollständig abgetragen ist, entsteht auf der nachfolgenden n-Schicht eine Passivierungsschicht, vermutlich eine Oxidschicht, durch die die weitere Ätzgeschwindigkeit um den Faktor 100 bis 1000 vermindert wird.

Zur Erziehung hoher Ätzgenauigkeit ist es wichtig, dass zwischen der zu ätzenden p-Schicht und der Ätzflüssigkeit stets optimale elektrische Feldbedingungen bestehen. Es hat sich aber gezeigt, dass diese nur bei kleinen Siliziumflächen gegeben und einigermassen reproduzierbar sind. Bei grösseren Siliziumflächen, etwa bei Scheiben (Wafer) von 4 bis viele Zentimeter Durchmesser (2 bis mehrere Zoll), tritt oftmals eine unkontrollierbare Menge von Defektstellen auf, die zu örtlich begrenzten oder auch zu relativ grossflächigen, vorzeitigen Ätzstopps und damit zu fehlerhaften und somit zu unbrauchbaren Ätzteilen führen, die zu vielen gleichzeitig aus einer solchen Scheibe hergestellt werden.

Es ist daher die Aufgabe der Erfindung, das bekannte elektrochemische Ätzverfahren für Silizium so zu verbessern, dass der genannte Nachteil überwunden wird.

Diese Aufgabe wird gelöst durch die Merkmale des kennzeichnenden Teils der unabhängigen Ansprüche. Die anderen Ansprüche geben Ausgestaltungen der Erfindung an.

Die verbesserte Ätzmethode ermöglicht gleichmässige und reproduzierbare Ätzergebnisse auch bei grossen Siliziumscheiben, durch die eine Serienfabrikation von preiswerten Silizium-Ätzteilen möglich wird.

Solche Ätzteile sind beispielsweise Drucksensoren, wobei auf den geätzten Teilen diesen zugeordnete elektrische Widerstände und/oder elektronische Schaltkreise in bekannter Fertigungstechnik angeordnet sind.

Im folgenden wird die Erfindung anhand von drei Figuren beispielsweise näher beschrieben. Es zeigen:

Fig. 1 - Schema einer Anordnung zum elektrochemischen Ätzen von Siliziumscheiben;

Fig. 2 - Verfeinertes Schema der Anordnung,

Fig. 3 - Diagramm der Potentialverteilung in der Anordnung.

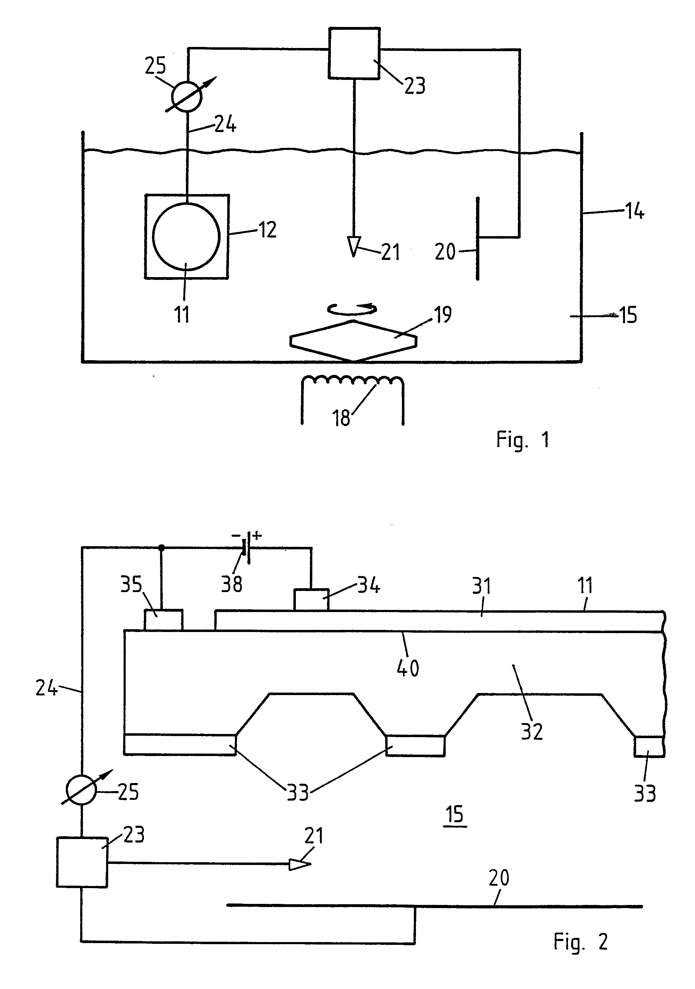

Fig. 1 zeigt schematisch eine Anordnung zum elektrochemischen Ätzen von Siliziumscheiben, z.B. zur Herstellung dünner Siliziumschichten. Die Siliziumscheibe 11 wird durch einen mechanischen Halter 12 in einem Ätzbad gehalten. Solche Scheiben sind mit verschiedenen Durchmessern im Handel erhältlich und werden oftmals entsprechend der angelsächsischen Sprachgewohnheit als Wafer bezeichnet.

Das Ätzbad besteht aus einem Gefäss 14, in dem sich eine Ätzflüssigkeit 15 befindet. Eine solche ist bevorzugt reine Kalilauge (KOH) in höherer Konzentration, z.B. 10-molar. Eine geregelte Heizung 18 hält die Flüssigkeit auf etwa 60°C und ein Rührer 19 sorgt für ständige Durchmischung. Zur Erzeugung des notwendigen elektrischen Feldes dienen eine Gegenelektrode 20, eine Referenzelektrode 21 und die elektrisch leitfähige Siliziumscheibe 11 zusammen mit einem 3-Elektroden-Potentiostat 23.

Die Gegenelektrode 20 ist niederohmig mit dem Potentiostat 23 verbunden, ist flächig ausgebildet und ist bevorzugt eine Platinelektrode.

Die Referenzelektrode 21 ist hochohmig mit dem Potentiostat 23 verbunden, in der Nähe der Siliziumscheibe 11 angeordnet und dient vor allem zur Einstellung einer wohldefinierten Potentialdifferenz zwischen der Siliziumscheibe 11 und der Ätzflüssigkeit 15.

In die Verbindungsleitung 24 zwischen der Siliziumscheibe 11 und dem Potentiostat 23 ist ein Strommesser 25 eingefügt, durch den der Strom zwischen der Gegenelektrode 20 und der Siliziumscheibe 11 messbar ist.

Das 3-Elektroden-Potentiostat 23 ist als käufliche Einheit eine Spannungsquelle, durch die sich die elektrischen Potentiale an den Elektroden 20 und 21 sowie an der Siliziumscheibe 11 in weiten Bereichen einstellen lassen. Der Strommesser 25 kann integrierender Bestandteil des Potentiostats sein.

Die Anordnung von Fig. 1 ist in der Praxis so ausgebildet, dass im Bereich der im wesentlichen planen, zu ätzenden Oberfläche der Siliziumscheibe 11 ein möglichst homogenes Feld besteht, dessen Äquipotentialflächen parallel zu dieser Oberfläche liegen. Die Siliziumscheibe 11 und die Gegenelektrode 20 sind daher abweichend von der Darstellung in Fig. 1 im wesentlichen parallel zueinander ausgerichtet. Jedoch ist diese Anordnung recht unkritisch, da die Ätzflüssigkeit 15 im Vergleich zur Siliziumscheibe 11 eine sehr hohe Leitfähigkeit aufweist.

Fig. 2 zeigt ein verfeinertes Bild von Fig. 1. Die Siliziumscheibe 11 ist sehr stark vergrössert und geschnitten dargestellt. Sie umfasst eine dünnere, z.B. etwa 10 μm dicke, n-leitende Schicht 31 und eine dickere p-leitende Schicht 32. Jede dieser Schichten 31, 32 reicht über wesentliche Bereiche der gesamten Scheibe 11, im Spezialfall über die gesamte Scheibe 11. Im folgenden werden die Schichten als n-Schicht 31 bzw. p-Schicht 32 bezeichnet.

Auf der offen liegenden Oberfläche der p-Schicht 32 ist eine Ätzmaske 33 angebracht, die die p-Schicht 32 an den nicht zu ätzenden Stellen gegen die Ätzflüssigkeit 15 abdeckt. Die Ätzmaske 33 kann beispielsweise aus Siliziumdioxid oder einem Edelmetall bestehen. An den zu ätzenden Stellen 37 ist die p-Schicht 32 mit verminderter Schichtdicke dargestellt, was einen laufenden Ätzvorgang andeutet.

Die n-(31) und die p-Schicht 32 besitzen eine gegenüber der Ätzflüssigkeit 15 geringe spezifische Leitfähigkeit, deren typischer Wert zwischen etwa 1 und 10Ωcm liegt.

Sowohl die n-Schicht 31 als auch p-Schicht 32 besitzen wenigstens einen ohmischen Kontakt 34 bzw. 35, z.B. in Form eines oder mehrerer Metallanschlüsse. Mit diesen Kontakten 34, 35 sind die Schichten 31 bzw. 32 an eine weitere Spannungsquelle 38 angeschlossen, und zwar so, dass die n-Schicht 31 positiv gegenüber der p-Schicht 32 gepolt ist. Hierdurch bildet sich an der gesamten Grenze zwischen der n-Schicht 31 und der p-Schicht 32 eine hochohmige Sperrschicht 40 aus, die Ströme zwischen den Schichten 31 und 32, und zwar sowohl Ströme direkt von einer Schicht zur anderen als auch Ströme über die Oberfläche der Siliziumscheibe 11, im Idealfall vollständig verhindert. Im praktischen Fall werden die Ströme so weitgehend verhindert oder so geleitet, dass sie an keiner Stelle der zu ätzenden Oberfläche der p-Schicht 32 zu einem unkontrollierten Ätzstopp führen. Die Anschlüsse und Kontakte 34, 35 sind selbstverständlich so isoliert, dass auch hierüber keine Störströme fliessen können.

Am Kontakt 35 der p-Schicht 32 ist die Verbindungsleitung 24 zum Potentiostat 23 angeschlossen, in die der Strommesser 15 eingefügt ist. Am Potentiostat 23 sind weiter - wie anhand von Fig. 1 beschrieben - die Referenzelektrode 21 und die Gegenelektrode 20 angeschlossen.

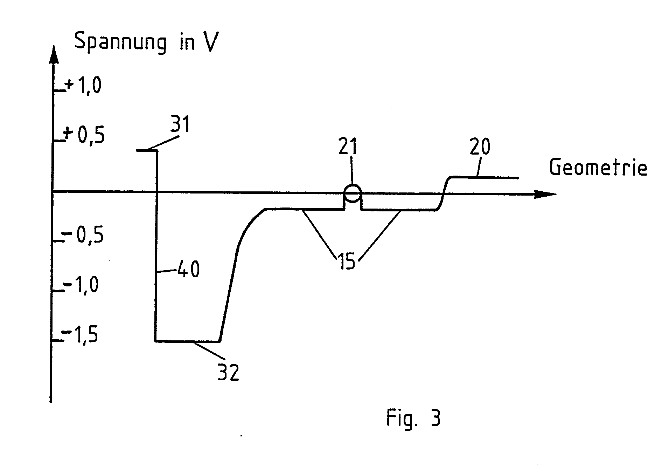

Fig. 3 zeigt ein Diagramm der Potentialverteilung in der Anordnung entsprechend Fig. 1 und 2. Auf der Ordinate ist der jeweilige Spannungswert bezüglich der Referenzelektrode 21 aufgetragen, auf der Abszisse die Geometrie der Vorrichtung, insbesondere Abstände und Schichtdicken in aus praktischen Gründen sehr unterschiedlichen Massstäben.

Die Referenzelektrode 21, dargestellt als kleiner Kreis, bildet den Bezugspunkt "O" der Vorrichtung und ist daher auf der Abszisse eingezeichnet. Die die Referenzelektrode 21 umgebende, gut leitfähige Ätzflüssigkeit 15 sowie die Gegenelektrode 20 befinden sich auf etwa gleichem Potential wie die Referenzelektrode 21. Die p-Schicht 32 ist dagegen gegenüber der Ätzflüssigkeit 15 deutlich negativ gepolt, und zwar bevorzugt etwa um 1,5 V. Diese Spannungsdifferenz muss auf der gesamten zu ätzenden Fläche etwa gleichmässig eingehalten werden. Die n-Schicht 31 befindet sich schliesslich auf einem Potential, das wenigstens um 0,6 V positiver ist als das der p-Schicht 32. Ein praktischer Wert für die Spannung der weiteren Spannungsquelle 38 beträgt somit 1 bis 2 V. Das bevorzugte Potential der n-Schicht 31 liegt gegenüber der Bezugselektrode 21 auf etwa -0,5 bis + 0,5 V.

Die Anordnung arbeitet wie folgt: Die zu ätzende Siliziumscheibe 11 wird auf der Seite ihrer p-Schicht 32 mit einer Ätzmaske 33 versehen und auf der entgegengesetzten Seite mit Kontakten 34 und 35, die zum einen die n-Schicht 31 und zum anderen die p-Schicht 32 ohmisch kontaktieren. Sodann werden die Leitung 24 und die weitere Spannungsquelle 38 an diese Kontakte angeschlossen, die Scheibe 11 am oder im Halter 12 befestigt und dieser zusammen mit der Scheibe 11 in die Ätzflüssigkeit 15 abgesenkt. Nach Einstellung der beschriebenen Potentiale am Potentiostat 23 beginnt der Ätzvorgang, der durch den Strom am Strommesser 25 kontrollierbar ist. Das Ende des Ätzvorganges durch den Ätzstopp an der Sperrschicht 40 zeigt sich durch eine charakteristische Änderung des Stromes an.

Die Anordnung weist wesentliche Vorteile gegenüber den bekannten Anordnungen auf. Sie erlaubt gleichmässiges und reproduzierbares Ätzen auch grosser Siliziumscheiben. Die Ätzgenauigkeit ist wesentlich verbessert und beträgt etwa ± 0,3 μm. Damit besteht die Möglichkeit, entsprechend tolerierte Strukturen zu ätzen.

Bei geeigneter Ausbildung des Halters 12 und der Elektroden 20 und 21 ist es natürlich möglich, gleichzeitig und parallel mehrere Siliziumscheiben 11 zu ätzen, was für eine Serienfabrikation wichtig ist.

Weiter ist es entsprechend dem Beschriebenen möglich, auch Siliziumscheiben 11 mit komplizierterer Schichtstruktur zu ätzen, z.B. mit einer Schichtfolge p/n/p, sogar beidseitig.

Mehrere Kontakte 34, 35 pro Siliziumscheibe 11 sind dann erforderlich, wenn entweder mehrere n-Schichten 31 und/oder mehrere p-Schichten 32 nicht in sich zusammenhängen, also Inseln bilden, oder wenn der effektiv wirksame Längswiderstand der n-Schicht 31 und/oder der p-Schicht 32 so gross ist, dass längs der Schichten 31, 32 Spannungsabfälle auftreten, die die örtlichen Oberflächenpotentiale ungünstig beeinflussen.

**Ansprüche**

1. Anordnung zum elektrochemischen Ätzen von Siliziumscheiben (11), wobei die Siliziumscheiben (11) eine n-leitende Schicht (31) und eine p-leitende Schicht (32) aufweisen, und wobei die p-leitende Schicht (32) entsprechend einer Ätzmaske (33) abätzbar ist, umfassend
ein Ätzbad (14, 15),
einen in das Ätzbad (14, 15) einbringbaren Halter (12) zum Halten wenigstens einer Siliziumscheibe (11),
eine Gegenelektrode (20),
eine Spannungsquelle, die zwischen der Gegenelektrode (20) und der Siliziumscheibe (11) eine Spannung so aufbaut, dass die Siliziumscheibe (11) negativ gegenüber der Ätzflüssigkeit (15) gepolt ist, und
einen Strommesser (25) zum Messen des elektrischen Stromes zwischen der Gegenelektrode (20) und der Siliziumscheibe (11),
dadurch gekennzeichnet,
-dass sowohl die n-leitende Schicht (31) als auch die p-leitende Schicht (32) der Siliziumscheibe (11) mit wenigstens einem ohmischen Kontakt (34, 35) versehen ist, der nicht mit der Ätzflüssigkeit (15) in elektrischen Kontakt kommt,
- dass die eine Spannungsquelle mit ihrem negativen Pol an den Kontakt (35) der p-leitenden Schicht (32) angeschlossen ist, und
-dass eine weitere Spannungsquelle (38) mit ihrem negativen Pol ebenfalls an den Kontakt (35) der p-leitenden Schicht (32) und mit ihrem positiven Pol an den Kontakt (34) der n-leitenden Schicht (31) angeschlossen ist.

2. Anordnung nach Anspruch 1,
dadurch gekennzeichnet,
dass eine Referenzelektrode (21) im Ätzbad (14, 15) vorgesehen ist, die hochohmig über ein 3-Elektroden-Potentiostat (23) mit der Gegenelektrode (20) und mit der p-leitenden Schicht (32) verbunden ist.

3. Anordnung nach Anspruch 1,
dadurch gekennzeichnet,
dass die Ätzflüssigkeit (15) konzentrierte, insbesondere etwa 10-normale Kalilauge ist, deren Temperatur etwa 60°C beträgt.

4. Elektrochemisches Ätzverfahren für Siliziumscheiben (11), die eine einseitig offen liegende p-leitende Schicht (32) und eine daran angrenzende n-leitende Schicht (31) aufweisen,
bei dem ein Ätzstopp an der Grenze zwischen den beiden Schichten (31, 32) stattfindet, und
bei dem die jeweilige Scheibe (11) gegenüber der Ätzflüssigkeit (15) auf negativem Potential liegt,
dadurch gekennzeichnet,
dass die n-leitende Schicht (31) gegenüber der p-leitenden Schicht (32) elektrisch so stark positiv vorgespannt wird, dass sich an der gesamten Grenzfläche zwischen den Schichten (31, 32) eine so hochohmige Sperrschicht (40) ausbildet, dass die separat kontaktierte p-leitende Schicht (32) an ihrer gesamten zu ätzenden Oberfläche stets einen etwa gleichen Potentialwert aufweist.

5. Ätzverfahren nach Anspruch 4,
dadurch gekennzeichnet,
dass die Potentialdifferenz zwischen der Ätzflüssigkeit (15) und der p-leitenden Schicht (32) etwa 1,5 V beträgt.

6. Ätzverfahren nach Anspruch 4,
dadurch gekennzeichnet,
dass die Potentialdifferenz zwischen der Ätzflüssigkeit (15) und der p-leitenden Schicht (32) als Potentialdifferenz zwischen einer hochohmig angeschlossenen, von der Ätzflüssigkeit umgebenen Referenzelektrode (21) und der p-leitenden Schicht (32) gemessen wird.

7. Ätzverfahren nach Anspruch 4,
dadurch gekennzeichnet,
dass die n-leitende Schicht (31) gegenüber der p-leitenden Schicht um wenigstens etwa 0,6 V positiv vorgespannt wird.

Fig. 1

Fig. 2

Spannung in V

+1,0

+0,5    31

21    20    Geometrie

-0,5

-1,0    40

-1,5

32

15

Fig. 3

Europäisches Patentamt

**EUROPÄISCHER RECHERCHENBERICHT**

Nummer der Anmeldung

EP  87 20 1178

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 664 762  (HIRATA) <br> * Insgesamt * & JP-A-61 30 038 <br><br> --- | 1,4 | C 25 F    3/12 <br> C 25 F    3/14 <br> H 01 L   21/306// <br> G 01 L    9/00 |
| A,D | THE BELL SYSTEM TECHNICAL JOURNAL, Band 49, Nr. 3, März 1970, Seiten 473-475, New York, US; H.A. WAGGENER: "Electrochemically controlled thinning of silicon" <br><br> ----- | 1,3 | |

| RECHERCHIERTE SACHGEBIETE (Int. Cl.4) |
|---|
| C 25 F    3/12 <br> C 25 F    3/14 <br> H 01 L   21/306 |

Der vorliegende Recherchenbericht wurde für alle Patentansprüche erstellt.

| Recherchenort | Abschlußdatum der Recherche | Prüfer |
|---|---|---|
| DEN HAAG | 14-10-1987 | VAN LEEUWEN R.H. |